# EUROPÄISCHE PATENTSCHRIFT

(11) **EP 1 830 404 B1**
(45) Veröffentlichungstag und Bekanntmachung des Hinweises auf die Patenterteilung: **05.08.2009**
(21) Anmeldenummer: 07002031.8
(22) Anmeldetag: 31.01.2007
(51) Int. Cl.: H01L 23/48, H01L 25/07

(54) **Leistungshalbleitermodul**
Power semiconductor module
Module semi-conducteur de puissance

(30) Priorität: 13.02.2006 DE 102006006423
(43) Veröffentlichungstag der Anmeldung: 05.09.2007
(73) Patentinhaber: SEMIKRON Elektronik GmbH & Co. KG, 90431 Nürnberg (DE)
(72) Erfinder: Popp, Rainer, 91580 Petersaurach (DE)

(56) Entgegenhaltungen:
- EP-A- 0 138 048
- EP-A- 1 367 643
- DE-A1- 4 237 632
- DE-A1- 19 719 703
- DE-A1- 19 903 875
- DE-C1- 10 127 947

## Beschreibung

Die Erfindung beschreibt ein Leistungshalbleitermodul in Druckkontaktausführung zur Anordnung auf einem Kühlbauteil. Einen Ausgangspunkt der Erfindung bilden Leistungshalbleitermodule wie sie beispielhaft aus der DE 197 19 703 A1 bekannt sind.

Derartige Leistungshalbleitermodule bestehen nach dem Stand der Technik aus einem Gehäuse mit mindestens einem darin angeordneten elektrisch isolierenden Substrat vorzugsweise zur direkten Montage auf einem Kühlbauteil. Das Substrat seinerseits besteht aus einem Isolierstoffkörper mit einer Mehrzahl darauf befindlicher gegeneinander isolierter metallischer Verbindungsbahnen und hierauf befindlichen und mit diesen Verbindungsbahnen schaltungsgerecht verbundenen Leistungshalbleiterbauelementen. Weiterhin weisen die bekannten Leistungshalbleitermodule Anschlusselemente für externe Last- und Hilfsanschlüsse sowie im Inneren angeordnete Verbindungselemente auf. Diese Verbindungselemente für schaltungsgerechte Verbindungen im Inneren des Leistungshalbleitermoduls sind meist als Drahtbondverbindungen ausgebildet.

Ebenfalls bekannt sind Druck kontaktierte Leistungshalbleitermodule, wie sie aus der DE 42 37 632 A1, der DE 199 03 875 A1 oder der DE 101 27 947 C1 bekannt sind. Bei erstgenannter Druckschrift weist die Druckeinrichtung ein stabiles, vorzugsweise metallisches, Druckelement zum Druckaufbau, ein elastisches Kissenelement zur Druck Speicherung und ein Brückenelement zur Druckeinleitung auf gesonderte Bereiche der Substratoberfläche auf. Das Brückenelement ist vorzugsweise ausgestaltet als ein Kunststoffformkörper mit einer dem Kissenelement zugewandten Fläche, von der eine Vielzahl von Druckfingern in Richtung der Substratoberfläche ausgehen.

Mittels einer derartigen Druckeinrichtung wird das Substrat auf ein Kühlbauteil gedrückt und somit der Wärmeübergang zwischen dem Substrat und dem Kühlbauteil dauerhaft sicher hergestellt. Das elastische Kissenelement dient hierbei der Aufrechterhaltung konstanter Druckverhältnisse bei unterschiedlichen thermischen Belastungen und über den gesamten Lebenszyklus des Leistungshalbleitermoduls.

Die DE 199 03 875 A1 bildet das bekannte Druckelement derart weiter, dass es einerseits ein besonders vorteilhaftes Verhältnis aus Gewicht und Stabilität aufweist und andererseits elektrisch isolierte Durchführungen aufweist. Hierzu ist das Druckelement als ein Kunststoffformkörper mit innen liegender Metallseele ausgebildet. Diese Metallseele weist Ausnehmungen für die Durchführung von Anschlusselementen, vorzugsweise Hilfsanschlusselementen in Federkontatkausführung, auf. Der Kunststoffformkörper umschließt diese Ausnehmungen derart, dass die Hilfsanschlusselemente mittels des Kunststoffformkörpers elektrisch von der Metallseele isoliert sind.

Es sind auch weitergebildete Druckelemente bekannt, die an ihrer dem Substrat zugewandten Oberfläche eine Vielzahl von Druckfingern aufweisen. Vorzugsweise weist hierbei die Metallseele noch eine voreingestellte Durchbiegung auf. In der Kombination beider Maßnahmen kann ein derartiges Druckelement die gesamte Funktionalität einer oben genannten Druckeinrichtung bereitstellen.

Aus der DE 101 57 947 C1 ist ein Leistungshalbleitermodul bekannt, wobei die Lastanschlusselemente derart ausgebildet sind, dass sie in Abschnitten eng benachbart senkrecht zur Substratoberfläche verlaufen und von dort ausgehende Kontaktfüße aufweisen, die den elektrischen Kontakt zu den Leiterbahnen herstellen und gleichzeitig Druck auf das Substrat ausüben und somit dessen thermischen Kontakt zu einem Kühlbauteil herstellen. Der Druck wird hierbei mit Mitteln nach dem Stand der Technik eingeleitet und gespeichert.

Weitere Leistungshalbleitermodule sind bekannt aus der EP 0 138 048 A2 und aus der EP 1 367 643 A2.

Der Erfindung liegt die Aufgabe zugrunde ein Leistungshalbleitermodul in Druckkontaktausführung vorzustellen, wobei die innere Isolation des Leistungshalbleitermoduls verbessert wird sowie die Ausbildung der Druckkontaktausführung vereinfacht wird.

Die Aufgabe wird erfindungsgemäß gelöst, durch die Maßnahmen der Merkmale des Anspruchs 1. Bevorzugte Ausführungsformen sind in den Unteransprüchen beschrieben.

Der erfinderische Gedanke geht aus von einer Anordnung eines Leistungshalbleitermoduls in Druckkontaktausführung auf einem Kühlbauteil mit mindestens einem Substrat, mindestens zwei hierauf angeordneten Leistungshalbleiterbauelementen, beispielhaft bipolaren Transistoren, einem Gehäuse und nach außen führenden Last- und Steueranschlusselementen. Das Substrat selbst weist einen Isolierstoffkörper auf und auf dessen erster, dem Inneren des Leistungshalbleitermoduls zugewandten Hauptfläche Leiterbahnen mit Lastpotential. Weiterhin weist das Substrat vorzugsweise auch mindestens eine Leiterbahn mit Steuerpotential zu Ansteuerung der Leistungshalbleiterbauelemente auf.

Das Leistungshalbleitermodul weist weiterhin Lastanschlusselemente jeweils ausgebildet als Metallformkörper mit einer Kontakteinrichtung, einem bandartigen Abschnitt und mit einer Mehrzahl von diesem ausgehenden Kontaktfüßen auf. Die jeweiligen bandartige Abschnitte sind parallel zur Substratoberfläche und von dieser beabstandet angeordnet. Die Kontaktfüße, die von dem bandartigen Abschnitt ausgehen reichen zum Substrat und bilden dort schaltungsgerecht die Kontakte der Lastanschlüsse aus. Vorzugsweise kontaktieren sie hierzu auf dem Substrat die Leiterbahnen mit Lastpotential, alternativ auch direkt die Leistungshalbleiterbauelemente.

Erfindungsgemäß bilden die Lastanschlusselemente einen Stapel wobei hierbei zwischen jeweils benachbarten Lastanschlusselementen im Bereich der jeweiligen bandartigen Abschnitte eine elastische Zwischenlage angeordnet ist. Diese Anordnung mehrerer elastischer Zwischenlage weist gegenüber dem Stand der Technik mit nur einem Druckspeicher, den Vorteil auf, dass die einzelnen Lastanschlusselement nicht starr sondern flexibel zueinander angeordnet sind und dadurch die Kontaktsicherheit wesentlich verbessert wird. Zudem werden Fertigungtoleranzen in der Länge der jeweiligen Kontaktfüße der einenzelene Lastanschlusselemente zueinander ausgeglichen. Durch die erfindungsgemäß Ausbildung des Stapels der Lastanschlusselemente drücken alle Kontaktfüße mit gleicher Kraft auf ihre jeweiligen Kontaktstellen auf dem Substrat bzw. auf den Leistungshalbleiterbauelementen.

Besonders bevorzugt kann es sein, wenn die bandartigen Abschnitte der Lastanschlusselemente und die Kontaktfüße aus einem flächigen Metallkörper in Stanz-Biege- Technik hergestellt sind, mit dem Kontakteinrichtungen (404, 424, 444) verbunden werden und anschließend im mit elastischen Zwischenlage (46) zu einem Stapel (4) laminiert werden.

Dieses Herstellungsverfahren hat den Vorteil, dass durch den vorgefertigten Stapel, beim Zusammenbau des Leistungshalbleitermoduls nur wenige einzelnen Komponenten zueinander anzuordnen sind.

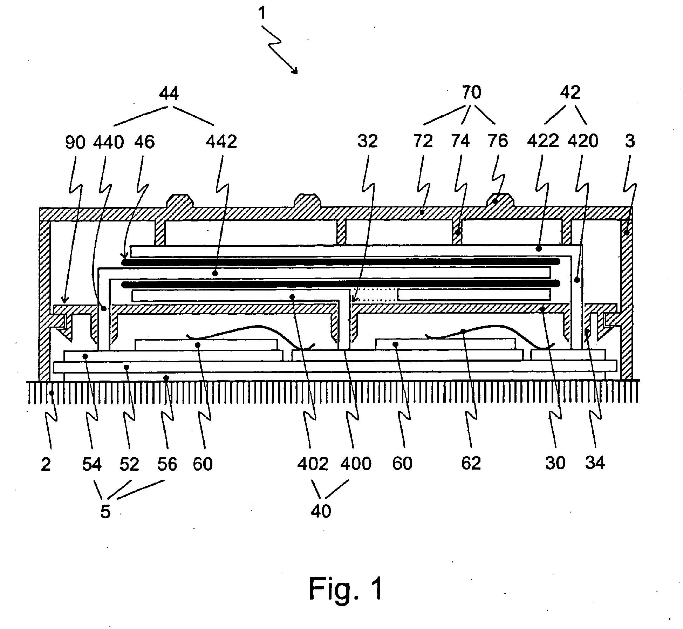

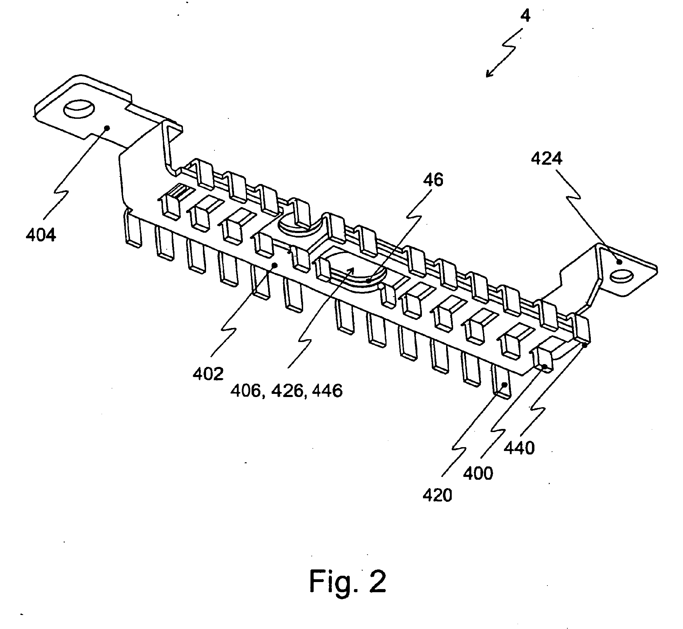

Die erfinderische Lösung wird an Hand der Ausführungsbeispiele der Fig. 1 und 2 weiter erläutert.

Fig. 1 zeigt einen Schnitt durch eine erfindungsgemäßes Leistungshalbleitermodul.

Fig. 2 zeigt in dreidimensionaler Darstellung einen Stapel aus Lastanschlusselementen des erfindungsgemäßen Leistungshalbleitermoduls.

Fig. 1 zeigt einen Schnitt durch ein erfindungsgemäßes Leistungshalbleitermodul (1). Dieses weist ein Gehäuse (3) mit einen rahmenartigen Gehäuseteil auf, der fest mit dem Kühlbauteil (2) der Anordnung verbunden ist. Der rahmenartige Gehäuseteil umschließt hierbei das mindestens eine Substrat (5). Dieses wiederum weist einen Isolierstoffkörper (52), vorzugsweise eine Isolierkeramik, wie Aluminiumoxid oder Aluminiumnitrit auf.

Auf der, dem Inneren des Leistungshalbleitermoduls (1) zugewandten, ersten Hauptfläche weist das Substrat (5) eine in sich strukturierte Metallkaschierung auf. Die einzelnen Abschnitte dieser vorzugsweise als Kupferkaschierung ausgestalteten Metallkaschierung bilden hierbei die Leiterbahnen (54) des Leistungshalbleitermoduls (1) aus. Die zweite Hauptfläche des Substrats (5) weist gemäß dem Stand der Technik eine nicht strukturierte Kupferkaschierung (58) auf.

Auf den Leiterbahnen (54) des Substrats (5) sind steuerbare und / oder ungesteuerte Leistungshalbleiterbauelemente (60) wie beispielhaft IGBTs (insulated gate bipolar Transistor) mit jeweils antiparallel geschalteten Freilaufdioden, oder MOS-FETs angeordnet. Diese sind schaltungsgerecht mit weiteren Leiterbahnen (54), beispielhaft mittels Drahtbondverbindungen (62), verbunden.

Die Lastanschlusselemente (40, 42, 44) mit den verschiedenen notwendigen Potentialen dienen der externen Verbindung der leistungselektronischen Schaltung im Inneren des Leistungshalbleitermoduls (1). Hierzu sind die Lastanschlusselemente (40, 42, 44) als Metallformkörper ausgebildet, die je einen bandartigen Abschnitt (402, 422, 442) parallel zur Substratoberfläche aufweisen. Die bandartigen Abschnitte (402, 422, 442) bilden hierbei einen Stapel (4, vgl. Fig. 2), wobei die bandartigen Abschnitte der einzelnen Lastanschlusselemente (40, 42, 44) jeweils mittels einer elastischen Zwischenlage (46) hier einem Silikonkissen voneinander beabstandet und gegeneinander elektrisch isoliert sind. Es ist besonders bevorzugt, wenn diese Silikonkissen (46) mit den bandartigen Abschnitten verklebt sind, da somit der Stapel (4) als eine Montageeinheit ausgebildet ist. Notwendige Hilfsanschlusselemente sind aus Gründen der Übersichtlichkeit in dieser Schnittzeichnung nicht dargestellt.

Vorzugsweise weist das erfindungsgemäße Leistungshalbleitermodul (1) eine als Isolierstoffformkörper (30) ausgebildete Zwischenlage zwischen dem Stapel der bandartigen Abschnitte (402, 422, 442) der Lastanschlusselemente (40, 42, 44) und dem Substrat (5) auf. Der lsolierstoffformkörper (30) weist Ausnehmungen (32) zur Durchführung der Kontaktfüße (400, 420, 440) des Stapels (4, vgl. Fig. 2) auf.

Die Druckeinrichtung (70) zur thermischen Verbindung des Leistungshalbleitermoduls (1) mit einem Kühlbauteil (2) und gleichzeitig zur elektrischen Kontaktierung der Lastanschlusselemente (40, 42, 44) mit den Leiterbahnen (54) des Substrats (5) wird gebildet durch ein Druckelement (72) zum Druckaufbau auf den Stapel (4, vgl. Fig. 2) Hierzu weist das Druckelement Druckfinger (74) nach dem Stand der Technik auf. Es kann auch bevorzugt sein, wenn zwischen dem Druckelement (72) mit flächiger Unterseite und dem Stapel (4) eine weitere elastische Schicht gleicher Ausgestaltung der Zwischenlage (46) angeordnet ist.

Das Druckelement (72) kann weiterhin gemäß dem Stand der Technik als Kunststoffformkörper mit geeigneter innen liegender Metallseele und äußeren Versteifungsstrukturen (76) ausgeführt sein. Es ist ebenso bevorzugt, wenn das Druckelement (72) gleichzeitig als Deckel des Leistungshalbleitermoduls (1) dient.

Fig. 2 zeigt in dreidimensionaler Darstellung einen Stapel (4) aus Lastanschlusselementen (40, 42, 44) des erfindungsgemäßen Leistungshalbleitermoduls. Dargestellt sind die Lastanschlusselemente (40, 42, 44), die jeweils eine Mehrzahl von Kontaktfüßen (400, 420, 440) aufweisen, die von den zugeordneten bandartigen Abschnitten (402, 422, 442) ausgehen. Die Kontakteinrichtungen (404, 424, 444) bilden die externen Anschlüsse des Leistungshalbleitermoduls.

Zwischen den bandartigen Abschnitten (402, 422, 442) sind als elastische Zwischenlage (46) jeweils als ein Silikonkissen mit einer Mindestdicke von 1 mm angeordnet. Hierbei bildete die jeweilige elastische Zwischenlage (46) gleichzeitig die elektrische Isolation der benachbarten Lastanschlusselemente (40, 42, 44), sowie das Druck übertragende und Druck speichernde Element des Leistungshalbleitermoduls aus.

Es ist besonders vorteilhaft, wenn die Lastanschlusselemente (40, 42, 44) im Bereich der bandartigen Abschnitte (402, 422, 442) mit den jeweiligen Zwischenlage (46) zu einer Montageeinheit verbunden sind. Dies kann beispielhaft durch eine Verklebeverbindung ausgebildet sein. Es ist allerdings besonders bevorzugt, wenn als Verbindungstechnik ein Laminierverfahren verwendet wird.

Der Stapel (4) weist weiterhin Ausnehmungen (406, 426, 446, 466) in den bandartigen Abschnitten (402, 422, 442) sowie den Zwischenlage (46) zur Durchführung von als Schraubenfedern ausgebildeten nicht dargestellten Hilfsanschlusselementen auf.

## Patentansprüche

1. Leistungshalbleitermodul (1) in Druckkontaktausführung, zur Anordnung auf einem Kühlbauteil , mit mindestens einem Substrat (5), mindestens zwei hierauf angeordneten Leistungshalbleiterbauelementen (60), einem Gehäuse (3) und nach außen führenden Last- (40, 42, 44) und Steueranschlusselementen und mit einer Druckeinrichtung (70) zur Druckeinleitung auf die Lastanschlusselemente zu deren elektrischen Kontaktierung mit Seiterbahnen (54) des substrats, wobei das Substrat (5) einen Isolierstoffkörper (52) aufweist und auf dessen erster dem Inneren des Leistungshalbleitermoduls zugewandten Hauptfläche besagte Leiterbahnen (54) mit Lastpotential angeordnet sind
wobei die Lastanschlusselemente jeweils als Metallformkörper mit mindestens einem Kontaktelement (404, 424) einem bandartigen Abschnitt (402, 422, 442) und mit von diesem ausgehenden Kontaktfüßen (400, 420, 440) ausgebildet sind, der
bandartige Abschnitt parallel zur Substratoberfläche und von dieser beabstandet angeordnet sind und die Kontaktfüße von dem bandartigen Abschnitt zum Substrat (5) reichen und dieses schaltungsgerecht kontaktieren, und
wobei die Lastanschlusselemente (40, 42, 44) einen Stapel bilden und hierbei zwischen jeweils benachbarten Lastanschlusselementen im Bereich der jeweiligen bandartigen Abschnitte (402, 422, 442) eine elastische Zwischenlage (46) angeordnet ist.

2. Leistungshalbleitermodul (1) nach Anspruch 1
wobei die elastische Zwischenlage (46) als ein Silikonkissen mit einer Mindestdicke von 1mm ausgebildet ist.

3. Leistungshalbleitermodul (1) nach Anspruch 1,
wobei die elastische Zwischenlage (46) gleichzeitig die elektrischen Isolation der hierzu benachbarten Lastanschlusselemente (40, 42, 44) bildet.

4. Leistungshalbleitermodul (1) nach Anspruch 3,
wobei die Lastanschlusselemente (40, 42, 44) im Bereich der bandartigen Abschnitte (402, 422, 442) zu einer Einheit verbunden sind, hierbei alle Lastanschlusselemente gegeneinander elektrisch isoliert sind und wobei die Druckeinrichtung auf diesen Stapel Druck einleitet und somit die Kontaktfüße (400, 420, 440) elektrisch leitend mit Leiterbahnen (54) des Substrats (5) verbunden sind.

5. Leistungshalbleitermodul (1) nach Anspruch 1,
wobei zwischen einem Druckelement (72) der Druckeinrichtung (70) und dem Stapel eine weitere elastische Schicht angeordnet ist.

6. Leistungshalbleitermodul (1) nach Anspruch 1
wobei der Stapel (4) durch Verkleben ausgebildet ist.

7. Leistungshalbleitermodul (1) nach einem der vorgenannten Ansprüche,
wobei die Druckeinrichtung (70) und der Stapel Ausnehmungen (406, 426, 446, 466) zur Durchführung von als Schraubenfedern ausgebildeten Hilfsanschlusselemente aufweisen.

## Claims

1. A power semiconductor module (1) in pressure contact design, for arranging on a heat sink (2), comprising at least one substrate (5), at least two power semiconductor components (60) disposed thereon, a housing (3) and outwardly-leading load (40, 42, 44) and control connection elements and comprising a pressure device (70) for introducing pressure onto the load connection elements for the electrical contacting thereof with conductor paths (54) of the substrate, wherein the substrate (5) comprises an insulating material body (52) and said conductor paths (54) with load potential are disposed on the first principal surface thereof, facing the interior of the power semiconductor module, wherein the load connection elements are each configured as metal shaped bodies having at least one contact element (404, 424), a strip-shaped section (402, 422, 442) and contact feet (400, 420, 440) emanating therefrom, the strip-shaped section is disposed parallel to the substrate surface and at a distance therefrom, and the contact feet extend from the strip-shaped section to the substrate (5) and contact these in a manner appropriate to the circuit, and wherein the load connection elements (40, 42, 44) form a stack and in this case, an elastic intermediate layer (46) is disposed between respectively adjacent load connection elements in the area of the respective strip-shaped sections (402, 422, 442).

2. The power semiconductor module (1) according to claim 1, wherein the elastic intermediate layer (46) is configured as a silicone cushion having a minimum thickness of 1 mm.

3. The power semiconductor module (1) according to claim 1, wherein the elastic intermediate layer (46) at the same time forms the electrical insulation of the load connection elements (40, 42, 44) adjacent hereto.

4. The power semiconductor module (1) according to claim 3, wherein the load connection elements (40, 42, 44) are connected to form a unit in the area of the strip-shaped sections (402, 422, 442), all load connection elements are hereby electrically insulated with respect to one another and wherein the pressure device introduces pressure onto this stack and the contact feet (400, 420, 440) are thus connected to the conductor paths (54) of the substrate (5) in an electrically conducting manner.

5. The power semiconductor module (1) according to claim 1, wherein a further elastic layer is disposed between a pressure element (72) of the pressure device (70) and the stack.

6. The power semiconductor module (1) according to claim 1, wherein the stack (4) is configured by adhesive bonding.

7. The power semiconductor module (1) according to any one of the aforesaid claims, wherein the pressure device (70) and the stack have recesses (406, 426, 446, 466) for the passage of auxiliary connecting elements configured as helical springs.

## Revendications

1. Module semiconducteur de puissance (1), en configuration avec contacts par pression, destiné à être monté sur un élément refroidisseur (2), avec au moins un substrat (5), au moins deux composants semiconducteurs de puissance (60) placés dessus, un boîtier (3) et des éléments de raccordement de charge (40, 42, 44) et de commande débouchant sur l'extérieur et avec un dispositif de pression (70) destiné à appliquer une pression sur les éléments de raccordement de charge afin d'assurer leur contact électrique avec des pistes conductrices (54) du substrat, le substrat (5) présentant un corps en matière isolante (52) et portant sur sa première surface principale, tournée vers l'intérieur du module semiconducteur de puissance, lesdites pistes conductrices (54) ayant un potentiel de charge,
dans lequel les éléments de raccordement de charge sont réalisés sous la forme de corps métalliques formés avec au moins un élément de contact (404, 424), un segment en forme de ruban (402, 422, 442) et des pattes de contact (400, 420, 440) partant de ce dernier, dans lequel le segment en forme de ruban est parallèle à la surface du substrat et est écarté de celle-ci et dans lequel les pattes de contact partent du segment en forme de ruban et s'étendent jusqu'au substrat (5) et réalisent des contacts conformes au circuit, et
dans lequel les éléments de raccordement de charge (40, 42, 44) forment une pile, une couche élastique intermédiaire (46) étant disposée entre deux éléments de raccordement de charge voisins considérés, au niveau de leurs segments en forme de ruban (402, 422, 442).

2. Module semiconducteur de puissance (1) selon la revendication 1, dans lequel la couche élastique intermédiaire (46) prend la forme d'un coussin de silicone d'une épaisseur minimale de 1 mm.

3. Module semiconducteur de puissance (1) selon la revendication 1, dans lequel la couche élastique intermédiaire (46) forme simultanément l'isolation électrique des éléments de raccordement de charge (40, 42, 44) qui lui sont adjacents.

4. Module semiconducteur de puissance (1) selon la revendication 3, dans lequel les éléments de raccordement de charge (40, 42, 44), au niveau des segments en forme de ruban (402, 422, 442), sont réunis en une unité, si bien que tous les éléments de raccordement de charge sont isolés électriquement les uns par rapport aux autres, et dans lequel le dispositif de pression exerce une pression sur cette pile, si bien que les pattes de contact (400, 420, 440) sont reliées de manière électriquement conductrice aux pistes conductrices (54) du substrat (5).

5. Module semiconducteur de puissance (1) selon la revendication 1, dans lequel une couche élastique supplémentaire est disposée entre la pile et un élément de pression (72) du dispositif de pression (70).

6. Module semiconducteur de puissance (1) selon la revendication 1, dans lequel la pile (4) est formée par collage.

7. Module semiconducteur de puissance (1) selon l'une des revendications précédentes, dans lequel le dispositif de pression (70) et la pile présentent des ouvertures (406, 426, 446, 466) destinées au passage d'éléments auxiliaires de raccordement prenant la forme de ressorts hélicoïdaux.
